# EUROPEAN PATENT APPLICATION

(11) **EP 3 968 040 A1**
(43) Date of publication of application: **16.03.2022**
(21) Application number: 19933291.7
(22) Date of filing: 21.06.2019
(51) Int. Cl.: G01R 35/04, G01R 11/24

(54) **ABNORMAL ELECTRICITY USE RECOGNITION METHOD AND DEVICE, AND COMPUTER READABLE STORAGE MEDIUM**

(71) Applicant: Siemens Aktiengesellschaft, 80333 München (DE)
(72) Inventor: LI, Ang, Beijing 100102 (CN); LI, Jing, Beijing 100010 (CN); LIU, Hao, Beijing 100102 (CN); WANG, Dan, Beijing 100102 (CN); HUA, Wentao, Beijing 100102 (CN)
(74) Representative: Isarpatent
(86) International application number: PCT/CN2019/092387
(87) International publication number: WO 2020/252785

(57) **Abstract**

An abnormal electricity use recognition method and device, and a computer readable storage medium. The method comprises: classifying a transformer into a public transformer or a dedicated transformer, the public transformer corresponding to a plurality of first users; the dedicated transformer corresponding to one second user (101); recognizing a first abnormal user from the first users on the basis of the smart meter reading of the public transformer and the smart meter reading of the first user; or recognizing the first abnormal user from the first users on the basis of the smart meter reading of the first user (102); and recognizing a second abnormal user from the second user on the basis of the smart meter reading of the second user or the smart meter reading of the dedicated transformer (103). Respective personalized anomaly recognition policies are used for the public transformer having a plurality of first users and the dedicated transformer having only one second user, thereby improving the recognition accuracy and speed.

## Description

### TECHNICAL FIELD

The present invention relates to the power field, and in particular to a method and device for recognizing abnormal electricity use and a computer-readable medium.

### BACKGROUND OF THE INVENTION

With the economic development of the society and the increase in power consumption, the problem of abnormal electricity uses (for example, power theft) has become more and more prominent, which not only hinders the development of power supply enterprises, but also seriously affects a country's economic development and social stability.

Smart meters are the intelligent terminals on a smart power grid. In addition to the basic power metering function of conventional meters, smart meters also have intelligent functions such as two-way multi-rate metering, user-side control, two-way data communication with multiple data transmission modes, etc., in order to adapt to the use of smart grids and new energies. Smart meters can prevent some low-level electricity theft behaviors. At present, there are electricity theft methods targeting smart meters.

In the prior art, during the process of recognizing electricity theft behaviors, transformers are not distinguished, but the same abnormality recognition strategy is used for all the users of all transformers. However, different transformers may serve different numbers of users and different industries, and this undistinguished electricity theft recognition strategy is low in accuracy and slow in the recognition speed.

### BRIEF SUMMARY OF THE INVENTION

The implementations of the present invention propose an abnormal electricity use recognition method and device, and a computer-readable medium.

The technical solution of the implementations of the present invention is as follows:
an abnormal electricity use recognition method, comprising:
classifying transformers, specifically as public transformers or dedicated transformers, wherein a public transformer corresponds to a plurality of first users, and a dedicated transformer corresponds to a second user;
recognizing a first abnormal user among the first users based on readings of a smart meter of a public transformer and readings of smart meters of the first users; or recognizing a first abnormal user among the first users based on readings of smart meters of the first users; and
recognizing a second abnormal user among the second users based on readings of smart meters of the second users or readings of smart meters of dedicated transformers.

It can be seen that, in the implementations of the present invention, distinctive strategies for abnormality recognition are used for public transformers with a plurality of first users and dedicated transformers each with a single second user, thereby improving recognition accuracy and speed.

In one implementation, recognizing a first abnormal user among the first users based on readings of a smart meter of a public transformer and readings of smart meters of the first users comprises:
determining first statistical electricity use data in a first time interval based on readings of the smart meter of the public transformer, and determining second electricity use data in the first time interval based on readings of the smart meters of the first users; and
recognizing a first abnormal user among the first users based on correlation analysis of the first statistical electricity use data and the second statistical electricity use data.

Therefore, for a public transformer, in consideration of the large number of its users, the first abnormal users can be quickly determined directly based on correlation analysis of the statistical electricity use data of the public transformer and the statistical electricity use data of the first users.

In one implementation, recognizing a first abnormal user among the first users based on readings of smart meters of the first users comprises:
determining first statistical electricity use data in a first time interval based on readings of the smart meters of the first users;
clustering the first users based on the first statistical electricity use data to form user clusters, and recognizing a first user that cannot be clustered into any user cluster as a first abnormal user; and
recognizing first users in each user cluster with the distance from the cluster center greater than a first threshold as first abnormal users.

It can be seen that, for a public transformer, a clustering algorithm is used to recognize the first abnormal users in order to ensure recognition accuracy.

In one implementation, recognizing a first abnormal user among the first users based on readings of a smart meter of a public transformer and readings of smart meters of the first users comprises:
determining first statistical electricity use data in a first time interval based on readings of the smart meter of the public transformer, determining second electricity use data in the first time interval based on readings of the smart meters of the first users, and recognizing a first abnormal user among the first users based on correlation analysis of the first statistical electricity use data and the second statistical electricity use data; and
clustering the first users based on the first statistical electricity use data to form user clusters, recognizing a first user that cannot be clustered into any user cluster as a first abnormal user, and recognizing first users in each user cluster with the distance from the cluster center greater than a first threshold as first abnormal users.

Therefore, for a public transformer, the two dimensions of correlation analysis and a clustering algorithm are used in combination to determine the first abnormal users, which can prevent leaving out any abnormal users.

In one implementation, recognizing a second abnormal user among the second users based on readings of smart meters of the second users comprises:
determining the electricity use modes of the second users based on readings of the smart meters of the second users;
determining third statistical electricity use data in a second time interval based on readings of the smart meters of the second users;
clustering the second users based on the third statistical electricity use data to form user clusters, and recognizing a second user that cannot be clustered into any user cluster as a second abnormal user; and
recognizing second users in each user cluster with the distance from the cluster center greater than a second threshold as the second abnormal users.

Therefore, for dedicated transformers, a clustering algorithm is used to recognize the second abnormal users in order to ensure recognition accuracy.

In one implementation, recognizing a second abnormal user among the second users based on readings of smart meters of dedicated transformers comprises:
determining the load factors of dedicated transformers based on readings of the smart meters of the dedicated transformers, recognizing a second user corresponding to a dedicated transformer with the load factor greater than a preset first load factor threshold as a second abnormal user, and recognizing a second user corresponding to a dedicated transformer with the load factor smaller than a preset second load factor threshold as a second abnormal user; or
determining the power factors of dedicated transformers based on readings of the smart meters of the dedicated transformers, recognizing a second user corresponding to a dedicated transformer with the power factor greater than a preset first power factor threshold as a second abnormal user, and recognizing a second user corresponding to a dedicated transformer with the power factor smaller than a preset second power factor threshold as a second abnormal user.

It can be seen that, for dedicated transformers, in consideration of the small number of their users, the second abnormal users can be recognized quickly directly based on comparison with thresholds for the power factor or the load factor.

In one embodiment, the method further comprises:
determining the load factors of dedicated transformers based on readings of the smart meters of the dedicated transformers, recognizing a second user corresponding to a dedicated transformer with the load factor greater than a preset first load factor threshold as a second abnormal user, and recognizing a second user corresponding to a dedicated transformer with the load factor smaller than a preset second load factor threshold as a second abnormal user; and
determining the power factors of dedicated transformers based on readings of the smart meters of the dedicated transformers, recognizing a second user corresponding to a dedicated transformer with the power factor greater than a preset first power factor threshold as a second abnormal user, and recognizing a second user corresponding to a dedicated transformer with the power factor smaller than a preset second power factor threshold as a second abnormal user.

Therefore, for dedicated transformers, the three dimensions of the power factor, the load factor and a clustering algorithm are used in combination to determine the second abnormal users, which can prevent leaving out any abnormal users.

An abnormal electricity use recognition device, comprising:
a classification module, used to classify transformers, specifically as public transformers or dedicated transformers, wherein a public transformer corresponds to a plurality of first users, and a dedicated transformer corresponds to a second user;
a first recognition module, used to recognize a first abnormal user among the first users based on readings of a smart meter of a public transformer and readings of smart meters of the first users; or recognize a first abnormal user among the first users based on readings of smart meters of the first users; and
a second recognition module, used to recognize a second abnormal user among the second users based on readings of smart meters of the second users or readings of smart meters of dedicated transformers.

It can be seen that, in the implementations of the present invention, distinctive strategies for abnormality recognition are used for public transformers with a plurality of first users and dedicated transformers each with a single second user, thereby improving recognition accuracy and speed.

In one implementation, the first recognition module is used to determine first statistical electricity use data in a first time interval based on readings of the smart meter of the public transformer, and determine second electricity use data in the first time interval based on readings of the smart meters of the first users; and recognize a first abnormal user among the first users based on correlation analysis of the first statistical electricity use data and the second statistical electricity use data.

It can be seen that, for a public transformer, in consideration of the large number of its users, the first abnormal users can be quickly determined based on correlation analysis of the electricity use mode of the public transformer and the electricity use mode of the first users.

In one implementation, the first recognition module is used to determine first statistical electricity use data in a first time interval based on readings of the smart meters of the first users; cluster the first users based on the first statistical electricity use data to form user clusters, and recognize a first user that cannot be clustered into any user cluster as a first abnormal user; and recognize first users in each user cluster with the distance from the cluster center greater than a first threshold as first abnormal users.

Therefore, for a public transformer, a clustering algorithm is used to recognize the first abnormal users in order to ensure recognition accuracy.

In one implementation, the first recognition module is used to determine first statistical electricity use data in a first time interval based on readings of the smart meter of the public transformer, determine second electricity use data in the first time interval based on readings of the smart meters of the first users, and recognize a first abnormal user among the first users based on correlation analysis of the first statistical electricity use data and the second statistical electricity use data; cluster the first users based on the first electricity use data to form user clusters, and recognize a first user that cannot be clusters into any user cluster as a first abnormal user; and recognize first users in each user cluster with the distance from the cluster center greater than a first threshold as first abnormal users.

Therefore, for a public transformer, the two dimensions of correlation analysis and a clustering algorithm are used in combination to determine the first abnormal users, which can prevent leaving out any abnormal users.

In one implementation, the second recognition module is used to determine third statistical electricity use data in a second time interval based on readings of the smart meters of the second users, cluster the second users based on the third statistical electricity use data to form user clusters, recognize a second user that cannot be clustered into any user cluster as a second abnormal user, and recognize second users in each user cluster with the distance from the cluster center greater than a second threshold as the second abnormal users.

Therefore, for dedicated transformers, a clustering algorithm is used to recognize the second abnormal users in order to ensure recognition accuracy.

In one implementation, the second recognition module is used to determine the load factors of dedicated transformers based on readings of the smart meters of the dedicated transformers, recognize a second user corresponding to a dedicated transformer with the load factor greater than a preset first load factor threshold as a second abnormal user, and recognize a second user corresponding to a dedicated transformer with the load factor smaller than a preset second load factor threshold as a second abnormal user; or, determine the power factors of dedicated transformers based on readings of the smart meters of the dedicated transformers, recognize a second user corresponding to a dedicated transformer with the power factor greater than a preset first power factor threshold as a second abnormal user, and recognize a second user corresponding to a dedicated transformer with the power factor smaller than a preset second power factor threshold as a second abnormal user.

It can be seen that, for dedicated transformers, in consideration of the small number of their users, the second abnormal users can be recognized quickly based on comparison with thresholds for the power factor or the load factor.

In one implementation, the second recognition module is also used to determine the load factors of dedicated transformers based on readings of the smart meters of the dedicated transformers, recognize a second user corresponding to a dedicated transformer with the load factor greater than a preset first load factor threshold as a second abnormal user, and recognize a second user corresponding to a dedicated transformer with the load factor smaller than a preset second load factor threshold as a second abnormal user; determine the power factors of dedicated transformers based on readings of the smart meters of the dedicated transformers, recognize a second user corresponding to a dedicated transformer with the power factor greater than a preset first power factor threshold as a second abnormal user, and recognize a second user corresponding to a dedicated transformer with the power factor smaller than a preset second power factor threshold as a second abnormal user.

Therefore, for dedicated transformers, the three dimensions of the power factor, the load factor and a clustering algorithm are used in combination to determine the second abnormal users, which can prevent leaving out any abnormal users.

An abnormal electricity use recognition device, comprising a processor and a memory;
the memory stores an application program that can be executed by the processor, which is used to cause the processor to execute the abnormal electricity use recognition method as described in any of the above paragraphs.

It can be seen that the implementations of the present invention also implement an abnormal electricity use recognition device in the processor-memory structure.

A computer-readable storage medium, wherein a computer-readable instruction is stored in it, and the computer-readable instruction is used to execute the abnormal electricity use recognition method as described in any of the above paragraphs.

It can be seen that the implementations of the present invention also implement a computer-readable storage medium comprising a computer-readable instruction used to execute an abnormal electricity use recognition method.

### BRIEF DESCRIPTION OF THE DRAWINGS

Figure 1 is a flowchart of the abnormal electricity use recognition method of the embodiments of the present invention.
Figure 2 is a schematic diagram of an exemplary topology of the power distribution network of the embodiments of the present invention.
Figure 3 is a schematic diagram of an exemplary processing process of the abnormal electricity use recognition of the embodiments of the present invention.
Figure 4 is a structural diagram of the abnormal electricity use recognition device of the embodiments of the present invention.
Figure 5 is a structural diagram of the abnormal electricity use recognition device in the processor-memory structure of the embodiments of the present invention.

In the drawings, the following reference numerals are used:

| Numeral | Meaning |
|---|---|
| 101 - 103 | Steps |
| 200 | Power distribution cable |
| 201 | Public transformer |
| 202 | First dedicated transformer |
| 203 | Second dedicated transformer |
| 204 | Meter of public transformer |
| 205 | First group user |
| 206 | Second group user |
| 207 | First household user |
| 208 | Second household user |
| 209 | Convenience store user |
| 210 | Smart meter of the first group user |

| | |
|---|---|
| 211 | Smart meter of the second group user |
| 212 | Smart meter of the first household user |
| 213 | Smart meter of the second household user |
| 214 | Smart meter of the convenience store user |
| 215 | Third dedicated transformer |
| 216 | Third group user |
| 217 | Smart meter of the third group user |
| 301 | Transformer on the power distribution network |
| 302 | Classification operation |
| 303 | Public transformer |
| 304 | Dedicated transformer |
| 305 | Reading of the meter of the public transformer |
| 306 | Reading of the smart meter of a user of the public transformer |
| 307 | Correlation analysis |
| 308 | Clustering |
| 309 | Clustering |
| 310 | Comparison of users of the same cluster |
| 311 | Comparison of a user with its historical data |
| 312 | Load factor or power factor |
| 313 | Comparison with a threshold |
| 314 | Summarization |
| 400 | Abnormal electricity use recognition device |
| 401 | Classification module |
| 402 | First recognition module |
| 403 | Second recognition module |
| 500 | Abnormal electricity use recognition device |
| 501 | Processor |

| | |
|---|---|
| 502 | Memory |

### DETAILED DESCRIPTION OF THE EMBODIMENTS

The present invention is further described in detail with reference to the drawings and the embodiments, so that its technical solution and advantages become clearer. It should be understood that the specific embodiments described here are only used to illustratively explain the present invention, and are not used to limit the scope of the present invention.

In order to be concise and intuitive in the description, the solution of the present invention is described below with reference to several representative embodiments. The large number of details in the embodiments are only used to help to understand the solution of the present invention. However, it is obvious that the technical solution of the present invention may not be limited to these details. In order to avoid unnecessarily obscuring the solution of the present invention, some embodiments are not described in detail, but only a framework is given. Hereinafter, "including" means "including but not limited to", and "according to..." means "at least according to..., but not limited to...". Due to Chinese language habits, when the quantity of an element is not specified hereinafter, it means that there may be one or several of the element, or it can be understood as there is at least one of it.

In consideration of the shortcoming that the same abnormality recognition strategy is used for all the users of all transformers in the prior art, the implementations of the present invention classify transformers as public transformers or dedicated transformers, and distinctive abnormality recognition strategies are used for public transformers and dedicated transformers, thereby improving recognition accuracy.

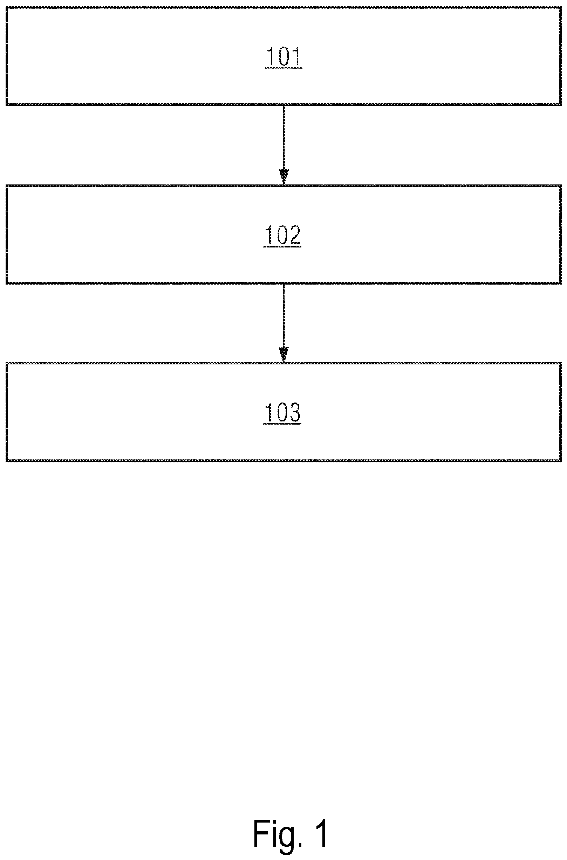

Figure 1 is a flowchart of the abnormal electricity use recognition method of the embodiments of the present invention.

As shown in Figure 1, the method comprises:
Step 101: classifying transformers, specifically as public transformers or dedicated transformers, wherein a public transformer corresponds to a plurality of first users, and a dedicated transformer corresponds to a second user.

Here, the transformers are preferably implemented as the distribution transformers on a power distribution network. For example, they may be implemented as medium-voltage distribution transformers of 6kV - 20kV or low-voltage distribution transformers of 220V.

The transformers are classified as public transformers or dedicated transformers depending on the number of users of a transformer. Among them, a public transformer is used to provide power to a plurality of users, and each user who obtains power from a public transformer is a first user. A dedicated transformer is used to provide power to one user, who is a second user. Generally, second users are group users who consume huge amounts of power, such as shopping malls, large factories or group companies; first users are individual users who consume relatively small amounts of power, such as households, convenience stores, individual vendors, etc.

Based on the specific topology of the power distribution network, there may be one or more public transformers. Similarly, there may also be one or more dedicated transformers. When there are a plurality of dedicated transformers, there are a plurality of second users.

Step 102: recognizing a first abnormal user among the first users based on readings of a smart meter of a public transformer and readings of smart meters of the first users; or recognizing a first abnormal user among the first users based on readings of smart meters of the first users.

Here, since a public transformer serves a plurality of users, based on abnormality recognition strategies applicable to public transformers, the first abnormal users are recognized from the first users, in order to accelerate recognition speed.

In one implementation, recognizing a first abnormal user among the first users based on readings of a smart meter of a public transformer and readings of smart meters of the first users comprises: determining first statistical electricity use data in a first time interval based on readings of the smart meter of the public transformer, and determining second electricity use data in the first time interval based on readings of the smart meters of the first users; and recognizing a first abnormal user among the first users based on correlation analysis of the first statistical electricity use data and the second statistical electricity use data.

Preferably, the first time interval may be a day, a week, a month, a quarter, a calendar year, etc. The first statistical electricity use data is the statistical electricity use data of a public transformer in the first time interval, and reflects the electricity use mode of the public transformer in the first time interval; the second statistical electricity use data is the statistical electricity use data of the first users in the first time interval, and reflects the electricity use mode of the first users in the first time interval. The first and the second statistical electricity use data may be specifically implemented as: the consumption curve in a day; the consumption curve in a week; the daily mean consumption curve in a calendar year, etc.

A first abnormal user can be recognized through correlation analysis of the first statistical electricity use data and the second statistical electricity use data. For example, the consumption curves of all the first users in a week are added up to obtain a combined consumption curve; the consumption curve of the public transformer in that week is compared with the combined consumption curve to analyze their correlation (for example, comparing the shape or amplitude by use of the autocorrelation method or the modified covariance method), to obtain a non-technical electrical loss curve (for example, the line loss curve). Then, the non-technical electrical loss curve is compared with the consumption curve of each first user separately for correlation analysis (for example, comparing the power spectrum by use of the autocorrelation method or the modified covariance method), to recognize a first abnormal user.

Therefore, for a public transformer, in consideration of the large number of its users, the first abnormal users can be quickly determined directly based on correlation analysis of the statistical electricity use data of the public transformer and the statistical electricity use data of the first users.

In one implementation, recognizing a first abnormal user among the first users based on readings of smart meters of the first users comprises: determining first statistical electricity use data in a first time interval based on readings of the smart meters of the first users; clustering the first users based on the first statistical electricity use data in the first time interval to form user clusters, and recognizing a first user that cannot be clustered into any user cluster as a first abnormal user; and recognizing first users in each user cluster with the distance from the cluster center greater than a first threshold as first abnormal users.

The process of clustering the first users based on the first statistical electricity use data to form user clusters specifically comprises: taking the first electricity use data of the first users as the clustering objects, wherein, assuming that there are M first users, then there are M corresponding first statistical electricity use data, and accordingly M clustering objects; randomly selecting K (K being smaller than M) clustering objects as the initial cluster centers, calculating the distance between each clustering object and each of the cluster centers, and assigning each clustering object to the cluster center nearest to it, wherein a cluster center and the clustering objects assigned to it represent one user cluster. Once all the clustering objects have been assigned, the center of each cluster is calculated again based on the existing clustering objects in a user cluster. The process will be repeated continuously until a certain end condition is met. The end condition may be any of the following: 1) no (or a minimum number of) clustering objects are re-assigned to a different user cluster; 2) no (or a minimum number of) cluster centers are further changed; or 3) the sum of squared errors reaches its local minimum. Preferably, the k-means clustering algorithm, K-Medoids or CLARANS may be used to execute the above clustering process.

It can be seen that, for a public transformer, a clustering algorithm may be used to recognize the first abnormal users in order to ensure recognition accuracy.

In one implementation, recognizing a first abnormal user among the first users based on reading of a smart meter of a public transformer and readings of smart meters of the first users comprises: determining first statistical electricity use data in a first time interval based on readings of the smart meter of the public transformer, determining second electricity use data in the first time interval based on readings of the smart meters of the first users, and recognizing a first abnormal user among the first users based on correlation analysis of the first statistical electricity use data and the second statistical electricity use data; clustering the first users based on the first electricity use data to form user clusters, and recognizing a first user that cannot be clustered into any user cluster as a first abnormal user; and recognizing first users in each user cluster with the distance from the cluster center greater than a first threshold as first abnormal users.

It can be seen that, for a public transformer, the two dimensions of correlation analysis and a clustering algorithm may be used in combination to determine the first abnormal users, which can prevent leaving out any abnormal users.

Step 103: recognizing a second abnormal user among the second users based on readings of smart meters of the second users or readings of smart meters of dedicated transformers.

Here, since each dedicated transformer serves one user, the second abnormal users are recognized from the second users based on abnormality recognition strategies applicable to dedicated transformers.

In one implementation, recognizing a second abnormal user among the second users based on readings of smart meters of the second users comprises: determining third statistical electricity use data in a second time interval based on readings of the smart meters of the first users; clustering the second users based on the third statistical electricity use data to form user clusters, and recognizing a second user that cannot be clustered into any user cluster as a second abnormal user; and recognizing second users in each user cluster with the distance from the cluster center greater than a second threshold as second abnormal users.

Preferably, the second time interval may be a day, a week, a month, a quarter, a calendar year, etc. The third statistical electricity use data is the statistical electricity use data of the second users in the second time interval, and reflects the electricity use mode of the second users in the second time interval. The third statistical electricity use data may be specifically implemented as: the consumption curve in a day; the consumption curve in a week; the daily mean consumption curve in a calendar year, etc.

The process of clustering the second users based on the third statistical electricity use data to form user clusters specifically comprises: taking the third electricity use data of a second user as one clustering object, wherein, assuming that there are J second users, then there are J corresponding third statistical electricity use data, and accordingly J clustering objects; randomly selecting T (T being smaller than J) clustering objects as the initial cluster centers, calculating the distance between each clustering object and each of the cluster centers, and assigning each clustering object to the cluster center nearest to it, wherein a cluster center and the clustering objects assigned to it represent one user cluster. Once all the clustering objects have been assigned, the center of each user cluster is calculated again based on the existing clustering objects in a user cluster. The process will be repeated continuously until a certain end condition is met. The end condition may be any of the following: 1) no (or a minimum number of) clustering objects are re-assigned to a different user cluster; 2) no (or a minimum number of) cluster centers are further changed; or 3) the sum of squared errors reaches its local minimum. Preferably, the k-means clustering algorithm, K-Medoids or CLARANS may be used to execute the above clustering process.

Therefore, for dedicated transformers, a clustering algorithm may be used directly to recognize the second abnormal users in order to ensure recognition accuracy.

In one implementation, recognizing a second abnormal user among the second users based on readings of smart meters of dedicated transformers comprises: determining the load factors of dedicated transformers based on readings of the smart meters of the dedicated transformers, recognizing a second user corresponding to a dedicated transformer with the load factor greater than a preset first load factor threshold as a second abnormal user, and recognizing a second user corresponding to a dedicated transformer with the load factor smaller than a preset second load factor threshold as a second abnormal user; or, determining the power factors of dedicated transformers based on readings of the smart meters of the dedicated transformers, recognizing a second user corresponding to a dedicated transformer with the power factor greater than a preset first power factor threshold as a second abnormal user, and recognizing a second user corresponding to a dedicated transformer with the power factor smaller than a preset second power factor threshold as a second abnormal user.

Therefore, for dedicated transformers, in consideration of the small number of their users, the second abnormal users can be recognized quickly based on comparison with thresholds for the power factor or the load factor.

In one implementation, recognizing a second abnormal user among the second users based on readings of smart meters of dedicated transformers comprises: determining third statistical electricity use data in a second time interval based on readings of the smart meters of the second users; clustering the second users based on the third statistical electricity use data to form user clusters, and recognizing a second user that cannot be clustered into any user cluster as a second abnormal user; recognizing second users in each user cluster with the distance from the cluster center greater than a second threshold as second abnormal users; determining the electricity use mode of a second user based on readings of a smart meter of the second user, clustering the second users based on the electricity use modes of the second users to form user clusters, recognizing a second user that cannot be clustered into any user cluster as a second abnormal user, and recognizing the second users in each user cluster with an abnormal electricity use mode as second abnormal users; determining the load factors of dedicated transformers based on readings of the smart meters of the dedicated transformers, recognizing a second user corresponding to a dedicated transformer with the load factor greater than a preset first load factor threshold as a second abnormal user, and recognizing a second user corresponding to a dedicated transformer with the load factor smaller than a preset second load factor threshold as a second abnormal user; determining the power factors of dedicated transformers based on readings of the smart meters of the dedicated transformers, recognizing a second user corresponding to a dedicated transformer with the power factor greater than a preset first power factor threshold as a second abnormal user, and recognizing a second user corresponding to a dedicated transformer with the power factor smaller than a preset second power factor threshold as a second abnormal user.

Therefore, for dedicated transformers, the three dimensions of the power factor, the load factor and a clustering algorithm may be used in combination to determine the second abnormal users, which can prevent leaving out any abnormal users.

After Step 103 is completed, the first abnormal users recognized in Step 102 and the second abnormal users recognized in Step 103 may be summarized, and a list of all the abnormal users can be shown to inspection personnel by means of a display interface, etc.

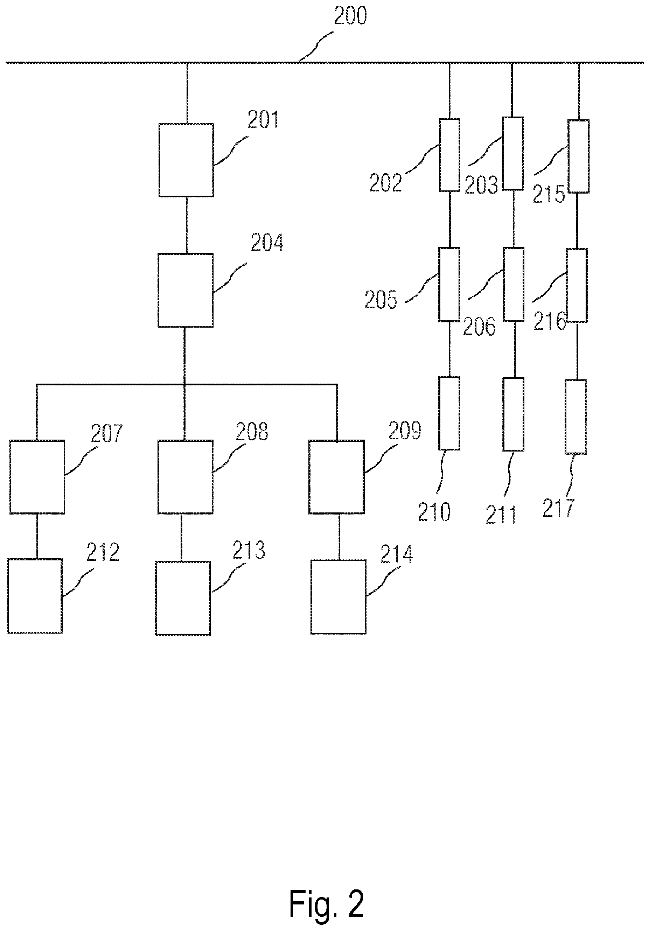

Figure 2 is a schematic diagram of an exemplary topology of the power distribution network of the embodiments of the present invention.

It can be seen from Figure 2 that the power distribution cable 200 is connected to a public transformer 201, a first dedicated transformer 202, a second dedicated transformer 203, and a third dedicated transformer 215. The power distribution cable 200 provides power to the public transformer 201, the first dedicated transformer 202, the second dedicated transformer 203, and the third dedicated transformer 215.

The public transformer 201 serves three users, namely a first household user 207, a second household user 208, and a convenience store user 209. The public transformer 201 is connected to a meter 204. The first household user 207 has its own smart meter 212, the second household user 208 has its own smart meter 213, and the convenience store user 209 has its own smart meter 214. The reading of the smart meter 212 is used to indicate the electricity consumption of the first household user 207; the reading of the smart meter 213 is used to indicate the electricity consumption of the second household user 208; and the reading of the smart meter 214 is used to indicate the electricity consumption of the convenience store user 209. The reading of the smart meter 214 is used to indicate the electricity consumption of the public transformer 201.

The dedicated transformer 202 serves one user, i.e., the first group user 205. The first group user 205 has its own smart meter 210. The reading of the smart meter 210 is used to indicate the electricity consumption of the first group user 205.

The dedicated transformer 203 serves one user, i.e., the second group user 206. The second group user 206 has its own smart meter 211. The reading of the smart meter 211 is used to indicate the electricity consumption of the second group user 206.

The dedicated transformer 215 serves one user, i.e., the third group user 216. The third group user 216 has its own smart meter 217. The reading of the smart meter 217 is used to indicate the electricity consumption of the third group user 216.

The abnormality recognition strategies applicable to the public transformer 201 include at least one of the following strategies:
Strategy 1: firstly, statistical data of the public transformer 201 (for example, the consumption curve in a day) is determined based on the readings of the meter 204 of the public transformer. Then, statistical data of the first household user 207 (similarly, the consumption curve in a day) is determined based on the readings of the smart meter 212 of the first household user 207, statistical data of the second household user 208 (similarly, the consumption curve in a day) is determined based on the readings of the smart meter 213 of the second household user 208, and statistical data of the convenience store user 209 (similarly, the consumption curve in a day) is determined based on the readings of the smart meter 214 of the convenience store user 209. Next, the statistical data of the first household user 207, the statistical data of the second household user 208 and the statistical data of the convenience store user 209 are added up to obtain combined statistical consumption data; correlation analysis is performed between the statistical data of the public transformer 201 and the combined statistical consumption data (for example, to compare the shape or amplitude), to obtain a non-technical electrical loss curve; correlation analysis is then performed on the statistical data of the first household user 207, the statistical data of the second household user 208 and the statistical data of the convenience store user 209 respectively against the non-technical electrical loss curve (for example, to compare the power spectrum), to recognize an abnormal user.
Strategy 2: statistical data of the first household user 207 (for example, the daily mean consumption curve in a calendar year) is determined based on the readings of the smart meter 212 of the first household user 207, statistical data of the second household user 208 (similarly, for example, the daily mean consumption curve in a calendar year) is determined based on the readings of the smart meter 213 of the second household user 208, and statistical data of the convenience store user 209 (similarly, for example, the daily mean consumption curve in a calendar year) is determined based on the readings of the smart meter 214 of the convenience store user 209. Then, the statistical data of the first household user 207, the statistical data of the second household user 208 and the statistical data of the convenience store user 209 are clustered to form user clusters, and a user that cannot be clustered into any user cluster is recognized as an abnormal user. For example, the clustering result shows that the first household user 207 and the second household user 208 can be clustered into the same user cluster (i.e., household user cluster), but the convenience store user 209 cannot be clustered into the user cluster, and then the convenience store user 209 can be recognized as an abnormal user. In addition, users in each user cluster with the distance from the cluster center greater than a preset threshold are also recognized as abnormal users. For example, an abnormal user with an abnormal electricity use mode is recognized in the user cluster of the first household user 207 and the second household user 208.
Strategy 3: Strategy 1 and Strategy 2 above are both used. Specifically: statistical data of the public transformer 201 (for example, the consumption curve in a day) is determined based on the readings of the meter 204 of the public transformer. Then, statistical data of the first household user 207 (similarly, the consumption curve in a day) is determined based on the readings of the smart meter 212 of the first household user 207, statistical data of the second household user 208 (similarly, the consumption curve in a day) is determined based on the readings of the smart meter 213 of the second household user 208, and statistical data of the convenience store user 209 (similarly, the consumption curve in a day) is determined based on the readings of the smart meter 214 of the convenience store user 209. Next, the statistical data of the first household user 207, the statistical data of the second household user 208 and the statistical data of the convenience store user 209 are added up to obtain combined statistical consumption data; correlation analysis is performed between the statistical data of the public transformer 201 and the combined statistical consumption data (for example, to compare the shape or amplitude), to obtain a non-technical electrical loss curve; correlation analysis is then performed on the statistical data of the first household user 207, the statistical data of the second household user 208 and the statistical data of the convenience store user 209 respectively against the non-technical electrical loss curve (for example, to compare the power spectrum), to recognize an abnormal user. Moreover, statistical data of the first household user 207 (for example, the daily mean consumption curve in a calendar year) is also determined based on the readings of the smart meter 212 of the first household user 207, statistical data of the second household user 208 (similarly, for example, the daily mean consumption curve in a calendar year) is determined based on the readings of the smart meter 213 of the second household user 208, and statistical data of the convenience store user 209 (similarly, for example, the daily mean consumption curve in a calendar year) is determined based on the readings of the smart meter 214 of the convenience store user 209. Then, the statistical data of the first household user 207, the statistical data of the second household user 208 and the statistical data of the convenience store user 209 are clustered to form user clusters, and a user that cannot be clustered into any user cluster is recognized as an abnormal user. For example, the clustering result shows that the first household user 207 and the second household user 208 can be clustered into the same user cluster (i.e., household user cluster), but the convenience store user 209 cannot be clustered into the user cluster, and then the convenience store user 209 can be recognized as an abnormal user. In addition, users in each user cluster with the distance from the cluster center greater than a preset threshold are also recognized as abnormal users. For example, an abnormal user with an abnormal electricity use mode is recognized in the user cluster of the first household user 207 and the second household user 208.

The abnormality recognition strategies applicable to the dedicated transformer 202, the dedicated transformer 203 and the dedicated transformer 215 include at least one of the following strategies:
Strategy 1: statistical data of the first group user 205 (for example, the consumption curve in a day) is determined based on the readings of the smart meter 210 of the first group user 205, statistical data of the second group user 206 (similarly, the consumption curve in a day) is determined based on the readings of the smart meter 211 of the second group user 206, and statistical data of the third group user 216 (similarly, the consumption curve in a day) is determined based on the readings of the smart meter 217 of the third group user 216. Then, the first group user 205, the second group user 206 and the third group user 216 are clustered based on the statistical data to form user clusters, and a user that cannot be clustered into any user cluster is recognized as an abnormal user. For example, assuming that the first group user 205 and the second group user 206 can be clustered into a user cluster of large factories but the third group user 216 cannot be clustered into the user cluster of large factories, then the third group user 216 can be recognized as an abnormal user. In addition, users in each user cluster with the distance from the cluster center greater than a preset threshold are recognized as abnormal users. For example, an abnormal user with an abnormal electricity use mode is recognized in the user cluster of the first group user 205 and the second group user 206.
Strategy 2: the load factor of the first dedicated transformer 202 is determined based on the readings of the smart meter 210 of the first group user 205, the load factor of the second dedicated transformer 203 is determined based on the readings of the smart meter 211 of the second group user 206, and the load factor of the third dedicated transformer 215 is determined based on the readings of the smart meter 216 of the third group user 217. The load factors of the first dedicated transformer 202, the second dedicated transformer 203 and the third dedicated transformer 215 are respectively compared with a preset load factor threshold, to recognize an abnormal user. For example, when it is found that the load factor of the first dedicated transformer 202 is greater than the upper threshold, the first group user 205 is recognized as an abnormal user; when it is found that the load factor of the first dedicated transformer 202 is smaller than the lower threshold, the first group user 205 is recognized as an abnormal user.
Strategy 3: the power factor of the first dedicated transformer 202 is determined based on the readings of the smart meter 210 of the first group user 205, the power factor of the second dedicated transformer 203 is determined based on the readings of the smart meter 211 of the second group user 206, and the power factor of the third dedicated transformer 215 is determined based on the readings of the smart meter 216 of the third group user 217. The power factors of the first dedicated transformer 202, the second dedicated transformer 203 and the third dedicated transformer 215 are respectively compared with a preset power factor threshold, to recognize an abnormal user. For example, when it is found that the power factor of the second dedicated transformer 203 is greater than the upper threshold, the second group user 206 is recognized as an abnormal user; when it is found that the power factor of the second dedicated transformer 203 is smaller than the lower threshold, the second group user 206 is recognized as an abnormal user.
Strategy 4: Strategy 1, Strategy 2 and Strategy 3 above are all used. Specifically: statistical data of the first group user 205 (for example, the consumption curve in a day) is determined based on the readings of the smart meter 210 of the first group user 205, statistical data of the second group user 206 (similarly, the consumption curve in a day) is determined based on the readings of the smart meter 211 of the second group user 206, and statistical data of the third group user 216 (similarly, the consumption curve in a day) is determined based on the readings of the smart meter 217 of the third group user 216. Then, the first group user 205, the second group user 206 and the third group user 216 are clustered based on the statistical data to form user clusters, and a user that cannot be clustered into any user cluster is recognized as an abnormal user. For example, assuming that the first group user 205 and the second group user 206 can be clustered into a user cluster of large factories but the third group user 216 cannot be clustered into the user cluster of large factories, then the third group user 216 can be recognized as an abnormal user. In addition, users in each user cluster with the distance from the cluster center greater than a preset threshold are recognized as abnormal users. For example, an abnormal user with an abnormal electricity use mode is recognized in the user cluster of the first group user 205 and the second group user 206.

In addition, the load factor of the first dedicated transformer 202 is determined based on the readings of the smart meter 210 of the first group user 205, the load factor of the second dedicated transformer 203 is determined based on the readings of the smart meter 211 of the second group user 206, and the load factor of the third dedicated transformer 215 is determined based on the readings of the smart meter 216 of the third group user 217. The load factors of the first dedicated transformer 202, the second dedicated transformer 203 and the third dedicated transformer 215 are respectively compared with a preset load factor threshold, and the user corresponding to a dedicated transformer with the load factor greater than the upper load factor threshold or smaller than the lower load factor threshold is recognized as an abnormal user.

Moreover, the power factor of the first dedicated transformer 202 is determined based on the readings of the smart meter 210 of the first group user 205, the power factor of the second dedicated transformer 203 is determined based on the readings of the smart meter 211 of the second group user 206, and the power factor of the third dedicated transformer 215 is determined based on the readings of the smart meter 216 of the third group user 217. The power factors of the first dedicated transformer 202, the second dedicated transformer 203 and the third dedicated transformer 215 are respectively compared with a preset power factor threshold, and the user corresponding to a dedicated transformer with the power factor greater than the upper power factor threshold or smaller than the lower power factor threshold is recognized as an abnormal user.

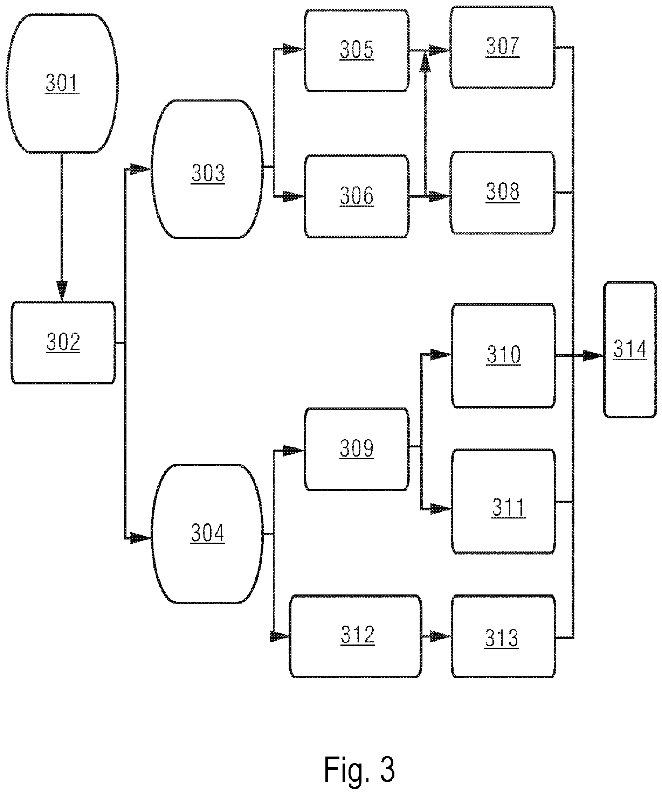

Based on the above description, Figure 3 is a schematic diagram of an exemplary processing process of the abnormal electricity use recognition of the embodiments of the present invention.

As shown in Figure 3, the classification operation 302 is performed on the transformer 301 on a power distribution network, thereby classifying the transformer 301 as a public transformer 303 or a dedicated transformer 304.

For a public transformer 303, the readings 305 of the meter of the public transformer and the readings 306 of the smart meter of a user of the public transformer are separately collected. Correlation analysis 307 is performed on the electricity use mode represented by the readings 305 of the meter of the public transformer and the electricity use mode represented by the reading 306 of the smart meter of a user of the public transformer, to recognize an abnormal user. Moreover, clustering 308 is performed on the user modes represented by the reading of the smart meters of the users of the public transformer, to recognize an abnormal user.

For a dedicated transformer 304, statistical electricity use data of the user is determined based on the reading of the smart meter of the user, and clustering 309 of the user is performed based on the statistical electricity user data. For users in the same user cluster, comparison among different users in the cluster 310 or comparison of a user with its historical data 311 may be performed, to recognize an abnormal user. Moreover, the load factor or power factor 312 of the dedicated transformer 304 may be determined, and an abnormal user can be recognized based on comparison between the load factor or power factor 312 with a threshold 313.

In summarization 314, all the abnormal users of the public transformer 303 and the dedicated transformer 304 are summarized, and shown to the inspection personnel by a display interface, etc.

The implementations of the present invention also propose an abnormal electricity use recognition device.

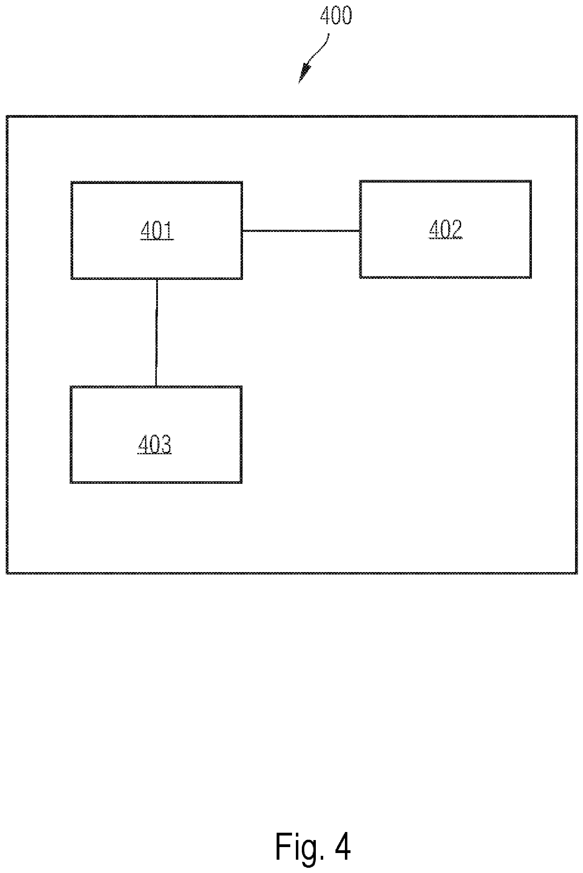

Figure 4 is a structural diagram of the abnormal electricity use recognition device of the embodiments of the present invention.

As shown in Figure 4, the abnormal electricity use recognition device 400 comprises:
a classification module 401, used to classify transformers, specifically as public transformers or dedicated transformers, wherein a public transformer corresponds to a plurality of first users, and a dedicated transformer corresponds to a second user;
a first recognition module 402, used to recognize a first abnormal user among the first users based on readings of a smart meter of a public transformer and readings of smart meters of the first users; or recognize a first abnormal user among the first users based on readings of smart meters of the first users; and
a second recognition module 403, used to recognize a second abnormal user among the second users based on readings of smart meters of the second users or readings of smart meters of dedicated transformers.

In one implementation, the first recognition module 402 is used to determine first statistical electricity use data in a first time interval based on readings of the smart meter of the public transformer, and determine second electricity use data in the first time interval based on readings of the smart meters of the first users; and recognize a first abnormal user among the first users based on correlation analysis of the first statistical electricity use data and the second statistical electricity use data.

In one implementation, the first recognition module 402 is used to determine first statistical electricity use data in a first time interval based on readings of the smart meters of the first users; cluster the first users based on the first statistical electricity use data to form user clusters, and recognize a first user that cannot be clustered into any user cluster as a first abnormal user; and recognize first users in each user cluster with the distance from the cluster center greater than a first threshold as first abnormal users.

In one implementation, the first recognition module 402 is used to determine first statistical electricity use data in a first time interval based on readings of the smart meter of the public transformer, determine second electricity use data in the first time interval based on readings of the smart meters of the first users, and recognize a first abnormal user among the first users based on correlation analysis of the first statistical electricity use data and the second statistical electricity use data; cluster the first users based on the first electricity use data to form user clusters, and recognize a first user that cannot be clusters into any user cluster as a first abnormal user; and recognize first users in each user cluster with the distance from the cluster center greater than a first threshold as first abnormal users.

In one implementation, the second recognition module 403 is used to determine third statistical electricity use data in a second time interval based on readings of the smart meters of the second users, cluster the second users based on the third statistical electricity use data to form user clusters, recognize a second user that cannot be clustered into any user cluster as a second abnormal user, and recognize second users in each user cluster with the distance from the cluster center greater than a second threshold as the second abnormal users.

In one implementation, the second recognition module 403 is used to determine the load factors of dedicated transformers based on readings of the smart meters of the dedicated transformers, recognize a second user corresponding to a dedicated transformer with the load factor greater than a preset first load factor threshold as a second abnormal user, and recognize a second user corresponding to a dedicated transformer with the load factor smaller than a preset second load factor threshold as a second abnormal user; or, determine the power factors of dedicated transformers based on readings of the smart meters of the dedicated transformers, recognize a second user corresponding to a dedicated transformer with the power factor greater than a preset first power factor threshold as a second abnormal user, and recognize a second user corresponding to a dedicated transformer with the power factor smaller than a preset second power factor threshold as a second abnormal user.

In one implementation, the second recognition module 403 is also used to determine the load factors of dedicated transformers based on readings of the smart meters of the dedicated transformers, recognize a second user corresponding to a dedicated transformer with the load factor greater than a preset first load factor threshold as a second abnormal user, and recognize a second user corresponding to a dedicated transformer with the load factor smaller than a preset second load factor threshold as a second abnormal user; determine the power factors of dedicated transformers based on readings of the smart meters of the dedicated transformers, recognize a second user corresponding to a dedicated transformer with the power factor greater than a preset first power factor threshold as a second abnormal user, and recognize a second user corresponding to a dedicated transformer with the power factor smaller than a preset second power factor threshold as a second abnormal user.

It can be seen that the implementations of the present invention also propose an abnormal electricity use recognition device in the structure of a processor and a memory.

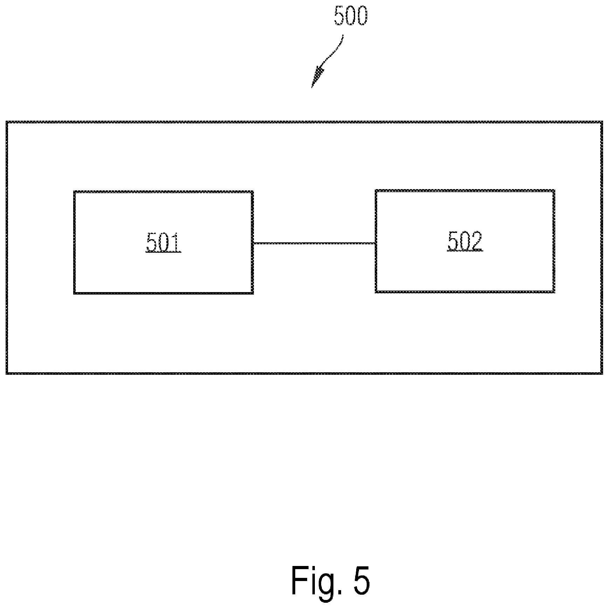

Figure 5 is a structural diagram of the abnormal electricity use recognition device in the processor-memory structure of the embodiments of the present invention.

A shown in Figure 5, the abnormal electricity use recognition device 500 comprises a processor 501 and a memory 502;
the memory 502 stores an application program that can be executed by the processor 501, which is used to cause the processor 501 to execute the abnormal electricity use recognition method as described in any of the above paragraphs.

The memory 502 may be specifically implemented as a variety of storage media such as electrically erasable programmable read-only memory (EEPROM), flash memory, programmable read-only memory (PROM), etc. The processor 501 may be implemented to comprise one or more central processing units or one or more field-programmable gate arrays, wherein the field-programmable gate array integrates the cores of one or more central processing units. Specifically, the central processing unit or central processing unit core may be implemented as a CPU or MCU.

It should be noted that not all steps and modules in the above flowcharts and structural diagrams are necessary, and some steps or modules can be ignored based on actual needs. The sequence of execution of the steps is not fixed, and can be adjusted as needed. A functional division of the modules is used only to facilitate the description. In actual implementation, a module may be implemented by multiple modules, and the functions of multiple modules may be implemented by a single module. These modules may be located in a single device or in different devices.

The hardware modules in each embodiment may be implemented mechanically or electronically. For example, a hardware module may comprise specially designed permanent circuits or logic devices (for example, dedicated processors, such as FPGA or ASIC) to complete specific operations. A hardware module may also comprise programmable logic devices or circuits temporarily configured by software (for example, general-purpose processors or other programmable processors) for performing specific operations. Whether to specifically use mechanical methods or dedicated permanent circuits or temporarily configured circuits (such as software configuration) to implement hardware modules may be determined according to cost and schedule considerations.

The present invention also provides a machine-readable storage medium, which stores an instruction used to cause a machine to execute the method described herein. Specifically, a system or device equipped with a storage medium may be provided, and the software program code for implementing the functions of any of the above implementations is stored on the storage medium, so that a computer (or CPU or MPU) of the system or device reads and executes the program code stored in the storage medium. In addition, the operating system operating on the computer may also be used to perform part or all of the actual operations through instructions based on the program code. It is also possible to write the program code read from the storage medium to the memory provided in an expansion board inserted into the computer or to the memory provided in an expansion unit connected to the computer, and then the program code-based instructions cause the CPU, etc. mounted on the expansion board or the expansion unit to perform part and all of the actual operations, so as to implement the functions of any of the above embodiments.

Implementations of the storage media used to provide the program code include floppy disks, hard disks, magneto-optical disks, optical disks (such as CD-ROM, CD-R, CD-RW, DVD-ROM, DVD-RAM, DVD-RW, DVD+RW), magnetic tapes, non-volatile memory cards and ROMs. Optionally, the program code may be downloaded from a server computer or a cloud via a communication network.

The present invention has been demonstrated and described in detail through the drawings and preferred embodiments above. However, the present invention is not limited to these disclosed embodiments. Based on the above embodiments, those skilled in the art can know that the code review methods in the different embodiments above may be combined to obtain more embodiments of the present invention, and these embodiments also fall within the scope of the present invention.

## Claims

1. An abnormal electricity use recognition method, **characterized in that** it comprises:
classifying transformers, specifically as public transformers or dedicated transformers, wherein a public transformer corresponds to a plurality of first users, and a dedicated transformer corresponds to a second user (101);
recognizing a first abnormal user among the first users based on readings of a smart meter of a public transformer and readings of smart meters of the first users; or recognizing a first abnormal user among the first users based on readings of smart meters of the first users (102); and
recognizing a second abnormal user among the second users based on readings of smart meters of the second users or readings of smart meters of dedicated transformers (103).

2. The abnormal electricity use recognition method as claimed in claim 1, **characterized in that** recognizing a first abnormal user among the first users based on readings of a smart meter of a public transformer and readings of smart meters of the first users (102) comprises:
determining first statistical electricity use data in a first time interval based on readings of the smart meter of the public transformer, and determining second electricity use data in the first time interval based on readings of the smart meters of the first users; and
recognizing a first abnormal user among the first users based on correlation analysis of the first statistical electricity use data and the second statistical electricity use data.

3. The abnormal electricity use recognition method as claimed in claim 1, **characterized in that** recognizing a first abnormal user among the first users based on readings of smart meters of the first users (102) comprises:
determining first statistical electricity use data in a first time interval based on readings of the smart meters of the first users;
clustering the first users based on the first statistical electricity use data to form user clusters, and recognizing a first user that cannot be clustered into any user cluster as a first abnormal user; and
recognizing first users in each user cluster with the distance from the cluster center greater than a first threshold as first abnormal users.

4. The abnormal electricity use recognition method as claimed in claim 1, **characterized in that** recognizing a first abnormal user among the first users based on readings of a smart meter of a public transformer and readings of smart meters of the first users (102) comprises:
determining first statistical electricity use data in a first time interval based on readings of the smart meter of the public transformer, determining second electricity use data in the first time interval based on readings of the smart meters of the first users, and recognizing a first abnormal user among the first users based on correlation analysis of the first statistical electricity use data and the second statistical electricity use data; and
clustering the first users based on the first statistical electricity use data to form user clusters, recognizing a first user that cannot be clustered into any user cluster as a first abnormal user, and recognizing first users in each user cluster with the distance from the cluster center greater than a first threshold as first abnormal users.

5. The abnormal electricity use recognition method as claimed in claim 1, **characterized in that** recognizing a second abnormal user among the second users based on readings of smart meters of the second users (103) comprises:
determining third statistical electricity use data in a second time interval based on readings of the smart meters of the second users;
clustering the second users based on the third statistical electricity use data to form user clusters, and recognizing a second user that cannot be clustered into any user cluster as a second abnormal user; and
recognizing second users in each user cluster with the distance from the cluster center greater than a second threshold as the second abnormal users.

6. The abnormal electricity use recognition method as claimed in claim 1, **characterized in that** recognizing a second abnormal user among the second users based on readings of smart meters of dedicated transformers (103) comprises:
determining the load factors of dedicated transformers based on readings of the smart meters of the dedicated transformers, recognizing a second user corresponding to a dedicated transformer with the load factor greater than a preset first load factor threshold as a second abnormal user, and recognizing a second user corresponding to a dedicated transformer with the load factor smaller than a preset second load factor threshold as a second abnormal user; or
determining the power factors of dedicated transformers based on readings of the smart meters of the dedicated transformers, recognizing a second user corresponding to a dedicated transformer with the power factor greater than a preset first power factor threshold as a second abnormal user, and recognizing a second user corresponding to a dedicated transformer with the power factor smaller than a preset second power factor threshold as a second abnormal user.

7. The abnormal electricity use recognition method as claimed in claim 5, **characterized in that** the method further comprises:
determining the load factors of dedicated transformers based on readings of the smart meters of the dedicated transformers, recognizing a second user corresponding to a dedicated transformer with the load factor greater than a preset first load factor threshold as a second abnormal user, and recognizing a second user corresponding to a dedicated transformer with the load factor smaller than a preset second load factor threshold as a second abnormal user; and
determining the power factors of dedicated transformers based on readings of the smart meters of the dedicated transformers, recognizing a second user corresponding to a dedicated transformer with the power factor greater than a preset first power factor threshold as a second abnormal user, and recognizing a second user corresponding to a dedicated transformer with the power factor smaller than a preset second power factor threshold as a second abnormal user.

8. An abnormal electricity use recognition device (400), **characterized in that** it comprises:
a classification module (401), used to classify transformers, specifically as public transformers or dedicated transformers, wherein a public transformer corresponds to a plurality of first users, and a dedicated transformer corresponds to a second user;
a first recognition module (402), used to recognize a first abnormal user among the first users based on readings of a smart meter of a public transformer and readings of smart meters of the first users; or recognize a first abnormal user among the first users based on readings of smart meters of the first users; and
a second recognition module (403), used to recognize a second abnormal user among the second users based on readings of smart meters of the second users or readings of smart meters of dedicated transformers.

9. The abnormal electricity use recognition device (400) as claimed in claim 8, **characterized in that**,
the first recognition module (402) is used to determine first statistical electricity use data in a first time interval based on readings of the smart meter of the public transformer, and determine second electricity use data in the first time interval based on readings of the smart meters of the first users; and recognize a first abnormal user among the first users based on correlation analysis of the first statistical electricity use data and the second statistical electricity use data.

10. The abnormal electricity use recognition device (400) as claimed in claim 8, **characterized in that**,
the first recognition module (402) is used to determine first statistical electricity use data in a first time interval based on readings of the smart meters of the first users; cluster the first users based on the first statistical electricity use data to form user clusters, and recognize a first user that cannot be clustered into any user cluster as a first abnormal user; and recognize first users in each user cluster with the distance from the cluster center greater than a first threshold as the first abnormal users.

11. The abnormal electricity use recognition device (400) as claimed in claim 8, **characterized in that**,
the first recognition module (402) is used to determine first statistical electricity use data in a first time interval based on readings of the smart meter of the public transformer, determine second electricity use data in the first time interval based on readings of the smart meters of the first users, and recognize a first abnormal user among the first users based on correlation analysis of the first statistical electricity use data and the second statistical electricity use data; cluster the first users based on the first electricity use data to form user clusters, and recognize a first user that cannot be clusters into any user cluster as a first abnormal user; and recognize first users in each user cluster with the distance from the cluster center greater than a first threshold as the first abnormal users.

12. The abnormal electricity use recognition device (400) as claimed in claim 8, **characterized in that**,
the second recognition module (403) is used to determine third statistical electricity use data in a second time interval based on readings of the smart meters of the second users, cluster the second users based on the third statistical electricity use data to form user clusters, recognize a second user that cannot be clustered into any user cluster as a second abnormal user, and recognize second users in each user cluster with the distance from the cluster center greater than a second threshold as the second abnormal users.

13. The abnormal electricity use recognition device (400) as claimed in claim 8, **characterized in that**,
the second recognition module (403) is used to determine the load factors of dedicated transformers based on readings of the smart meters of the dedicated transformers, recognize a second user corresponding to a dedicated transformer with the load factor greater than a preset first load factor threshold as a second abnormal user, and recognize a second user corresponding to a dedicated transformer with the load factor smaller than a preset second load factor threshold as a second abnormal user; determine the power factors of dedicated transformers based on readings of the smart meters of the dedicated transformers, recognize a second user corresponding to a dedicated transformer with the power factor greater than a preset first power factor threshold as a second abnormal user, and recognize a second user corresponding to a dedicated transformer with the power factor smaller than a preset second power factor threshold as a second abnormal user.

14. The abnormal electricity use recognition device (400) as claimed in claim 12, **characterized in that**,
the second recognition module (403) is also used to determine the load factors of dedicated transformers based on readings of the smart meters of the dedicated transformers, recognize a second user corresponding to a dedicated transformer with the load factor greater than a preset first load factor threshold as a second abnormal user, and recognize a second user corresponding to a dedicated transformer with the load factor smaller than a preset second load factor threshold as a second abnormal user; determine the power factors of dedicated transformers based on readings of the smart meters of the dedicated transformers, recognize a second user corresponding to a dedicated transformer with the power factor greater than a preset first power factor threshold as a second abnormal user, and recognize a second user corresponding to a dedicated transformer with the power factor smaller than a preset second power factor threshold as a second abnormal user.

15. An abnormal electricity use recognition device (500), **characterized in that** it comprises a processor (501) and a memory (502);
the memory (502) stores an application that can be executed by the processor (501), which is used to cause the processor (501) to execute the abnormal electricity use recognition method as claimed in any of claims 1 to 7.

16. A computer-readable storage medium, **characterized in that** a computer-readable instruction is stored in it, and the computer-readable instruction is used to execute the abnormal electricity use recognition method as claimed in any of claims 1 to 7.
